# EUROPÄISCHE PATENTSCHRIFT

(11) **EP 1 983 400 B1**
(45) Veröffentlichungstag und Bekanntmachung des Hinweises auf die Patenterteilung: **29.03.2017**
(21) Anmeldenummer: 07464003.8
(22) Anmeldetag: 20.04.2007
(51) Int. Cl.: G06F 1/025, H03K 7/08

(54) **PDM-Kanalsteuerung mit Speicherdirektzugriff**
PWM channel controller with direct memory access
Dispositif de réglage des canaux à modulation de largeur d'impulsion utilisant un acces direct à la mémoire

(43) Veröffentlichungstag der Anmeldung: 22.10.2008
(73) Patentinhaber: Continental Automotive GmbH, 30165 Hannover (DE)
(72) Erfinder: Botoaca, Andrei, 300125 Timisoara (RO); Klinger, Jürgen, 93049 Regensburg (DE); Reichow, Dirk, 93173 Wenzenbach (DE)

(56) Entgegenhaltungen:
- WO-A-93/23912
- DE-A1- 19 620 207
- US-A- 5 248 900
- US-A- 5 793 808
- US-A- 6 094 079
- US-A1- 2004 207 466
- MICHAEL DAY: "PWM dimming enhances color purity in high-end LED video displays" EETIMES EUROPE ONLINE, [Online] 31. Oktober 2005 (2005-10-31), Seiten 1-2, XP002456004 Gefunden im Internet: URL:http://eetimes.eu/173401243?pgno=2> [gefunden am 2007-10-22]
- ANDY GAYNE: "AVR136: Low-Jitter Multi-Channel Software PWM, Rev. 8020A-AVR-05/06"[Online] Mai 2006 (2006-05), Seiten 1-5, XP002456005 Gefunden im Internet: URL:http://www.atmel.com/dyn/resources/pro d_documents/doc8020.pdf> [gefunden am 2007-10-22]

## Beschreibung

Die Erfindung betrifft die Steuerung von elektrischen Verbrauchern in Kraftfahrzeugen und bezieht sich insbesondere auf die pulsdauermodulierte Ansteuerung von Licht- und Beleuchtungseinrichtungen mittels eines Karosseriesteuergeräts.

Zur Verbesserung der Sicherheit und des Komforts von Kraftfahrzeugen werden zunehmend so genannte Karosseriesteuergeräte (englisch: Body Control Unit; abgek. BCU) eingesetzt, die bestimmte Funktionen des Fahrzeugs, wie z.B. die als Airbag bezeichneten Prallkissen, Klimaanlage, Scheibenwischer, Zugangssysteme, Schiebedach und vor allem auch die internen und externen Beleuchtungsanlagen steuern. Karosseriesteuergeräte vereinen im Allgemeinen mehrere Funktionen in einem Gehäuse und umgekehrt sind üblicherweise mehrere dieser Geräte im Fahrzeug verteilt angeordnet, deren Funktion in einer Master/Slave-Architektur über ein Hauptsteuergerät gesteuert wird.

Karosseriesteuergeräte sind in der Regel modular aufgebaut, leicht anpassbar und ermöglichen die Integration verschiedener Steuerungsfunktionen auf kleinstem Raum. Mittels der durch sie möglichen Reduzierung der Steckverbinder und Kabelbäume im Fahrzeug bieten sie ein Höchstmaß an Zuverlässigkeit und Wirtschaftlichkeit.

Gewöhnlich enthält ein Karosseriesteuergerät zumindest zwei Untereinheiten, ein Logikmodul und ein Leistungsmodul. Das Logikmodul besitzt meist die Funktionalität eines programmierbaren Knotens, während das Leistungsmodul die einzelnen Verbraucher des Fahrzeugs entsprechend den Vorgaben des Logikmoduls steuert. Zur Steuerung der Beleuchtungsanlagen eines Kraftfahrzeugs werden die Steuersignale an die entsprechenden Einheiten, meist Leistungstransistoren oder dergleichen des Leistungsmoduls übertragen, die dann die eigentliche Steuergröße, beispielsweise die Versorgungsspannung oder den Versorgungsstrom, der jeweiligen lichttechnischen Einrichtung auf der Grundlage dieser Steuersignale erzeugen.

Die Beleuchtungsanlage von Kraftfahrzeugen umfasst im Allgemeinen Schaltungsabschnitte für die Fahrzeugscheinwerfer, die Signalleuchten des Fahrzeugs, wie z.B. die Heckleuchten, Fahrtrichtungs- und Warnanzeiger, sowie die Innenraum- und Instrumentenbeleuchtung. Zur Verbesserung der elektromagnetischen Verträglichkeit (EMV) des Bordnetzes, insbesondere im Hinblick auf die Funkentstörung, aber auch zur Erhöhung der Zuverlässigkeit und Lebensdauer der Beleuchtungseinrichtungen, wird die zum Betrieb der Leuchtmittel erforderliche Versorgungsspannung nicht unmittelbar an diese angelegt. Stattdessen wird eine pulsdauermodulierte (PDM) Versorgungsspannung verwendet, wodurch sich schädliche Überspannungsspitzen vermeiden lassen und die fehleranfällige Übertragung geringer Spannungen bei reduzierter Lichtemission umgangen wird.

Die Pulsdauermodulation der Versorgungsspannung für Leuchtmittel ermöglicht einerseits das langsame Hochfahren der effektiven Versorgungsspannung z.B. für die Scheinwerferlampen eines Fahrzeugs, wodurch sich die Lebensdauer dieser Leuchtmittel beträchtlich erhöht; andererseits kann damit auch der zeitliche Verlauf der Lichtemission von Leuchtmitteln, wie beispielsweise in Blinkern oder in an die Umgebungshelligkeit angepassten Instrumenten- oder Armaturenbrettbeleuchtungen zuverlässig gesteuert werden.

Hierzu wird in der logischen Untereinheit des Karosseriesteuergeräts üblicherweise ein als integrierter Schaltkreis ausgebildeter Mikrosteuerbaustein verwendet, der eine je nach Bauart unterschiedliche Anzahl von Ausgängen besitzt, an denen z.B. mittels eines Capture/Compare-Mechanismus Signale mit Pulsmustern ausgegeben werden können. Bei einer Konfiguration dieser Ausgänge zur Ausgabe von pulsdauermodulierten Signalen bezeichnet man diese als Hardware-PDM-Kanäle bzw. HW-PDM-Kanäle. Gegenwärtig werden in Karosseriesteuergeräten als MCUs (von englisch microcontroller unit) bezeichnete Mikrosteuerbausteine mit 4, 6 oder 8 dieser so genannten HW-PDM-Kanäle verwendet. Parameter der über diese Kanäle implementierten Pulsdauermodulation sind die meist vorgegebene Frequenz der Impulse und deren Tastverhältnis, d.h. die Impulsdauer im Verhältnis zur Periodendauer eines PDM-Signals, das auch als Füllfaktor bezeichnet wird. Hierzu müssen pro Kanal zwei Zeitgeber (Timer) der MCUs verwendet werden: ein Timer zur Regelung der Frequenz und ein Timer zur Steuerung des Füllfaktors.

In diesem Zusammenhang sei darauf verwiesen, dass, sofern im Einzelnen nicht explizit anders angegeben, in dieser Schrift durchgehend und abweichend vom deutschen Sprachgebrauch der Begriff 'steuern' gleichbedeutend mit dem Begriff 'regeln' verwendet wird. Dies betrifft auch alle grammatikalischen Abwandlungen beider Begriffe. In dieser Schrift kann der Begriff 'Steuerung' daher ebenso eine Rückführung einer Regelgröße bzw. deren Messwerts umfassen, wie sich der Begriff 'Regelung' auf eine einfache Steuerkette beziehen kann.

Die Verwendung der HW-PDM-Kanäle führt jedoch zu Problemen mit der elektromagnetischen Verträglichkeit des gesteuerten Systems, da die pulsdauermodulierten Impulse der einzelnen Steuerkanäle alle gleichzeitig zu Beginn jeder Periode eingeschaltet werden, und, da sich die mit diesen Steuersignalen geschalteten Versorgungsströme der angesteuerten Verbraucher addieren, der Gesamtstrom des Bordnetzes somit einen großen Sprung aufweist. Ferner ist die Anzahl der HW-PDM-Kanäle einer MCU meist so begrenzt, dass nicht alle gewünschten Verbraucher des Kraftfahrzeugs damit gesteuert werden können. Die Verwendung mehrer MCUs in einem Karosseriesteuergerät ist wirtschaftlich jedoch nicht vertretbar.

Bei dem in der US 5 793 808 vorgestellten System werden von Sensoren während eines Abtastzeitraums erfasste Parameter von einem Prozessor als Sensorsignale über Eingangskanäle gelesen und mit Zielwerten verglichen. Aus dem Vergleich bestimmt der Prozessor für jeden Kanal eines PDM-Signals ein bestimmtes Tastverhältnis.

Aus dem Tastverhältnis ergibt sich für den jeweiligen Kanal ein bestimmtes Verhältnis von Ein- zu Auszeit. Eine Änderung von einem Kanalzustand in einen anderen erfolgt nur bei einem Übergang von einem Taktzyklus zum nächsten. Innerhalb eines Taktzyklus' (z.B. A2 mit (t1+t2)/2 < t < (t2+t1)) werden die Zustände aller Kanäle zusammen in Form eines digitalen Worts angegeben, so dass man eine Kodierung der Tastverhältnisse aller Kanäle als Serie digitaler Wörter erhält. Jedes einzelne der Wörter ist für genau einen Taktzyklus gültig. Jedes einzelne Bit eines solchen Worts ist dabei jeweils genau einem der Kanäle zugeordnet. Sein jeweiliger Wert (0/1) bestimmt den gewünschten Zustand (An/Aus) dieses Kanals während des entsprechenden Taktzyklus'. Die einzelnen, dem Schaltzustand aller Kanäle zu den jeweiligen Taktzyklen entsprechenden Wörter werden in der gewünschten chronologischen Reihenfolge in aneinandergrenzende Speicherplätze eines RAMs geschrieben.

Aus diesem RAM werden die digitalen Wörter von einem DMA der Reihe nach ausgelesen und in den Ausgang des DMA geschrieben. Hat das DMA das letzte Wort erreicht, so erhält es vom Prozessor die Anweisung, die ausgelesene Sequenz zu wiederholen. Das DMA wiederholt die Wortsequenz bis zum nächsten Abtastzeitraum, bei dem die im RAM gespeicherte Wortfolge unter Verwendung der nun neu abgetasteten Sensorwerte aktualisiert wird. Die Steuerung der Aktoren erfolgt mittels Haltegliedern, die die jeweiligen Ausgänge des DMA bis zum jeweils nächsten Taktzyklus (der Zeitpunkt der Gültigkeit des nächsten Wortes) der Impulsbreitenmodulation aufrechterhalten.

Um Stromspitzen zu vermeiden sollen bei einer der beschriebenen Ausführungsform nicht alle Kanäle gleichzeitig eingeschaltet werden. Um dies zu erreichen, werden die Kanäle in Gruppen eingeteilt, wobei bei einer Gruppe von Kanälen die "Aus"-Zeiten den "Ein"-Zeiten vorangehen, während bei der anderen Gruppe in umgekehrter Weise die "Ein"-Zeiten den "Aus"-Zeiten vorangehen.

Ausgehend hiervon liegt der Erfindung die Aufgabe zugrunde, ein Karosseriesteuergerät anzugeben, das eine elektromagnetisch verträgliche pulsdauermodulierte Steuerung von elektrischen Verbrauchern in einem Kraftfahrzeug ermöglicht, und dessen PDM-Steuerkanäle nicht auf eine bestimmte Anzahl begrenzt sind.

Die Aufgabe wird gemäß den unabhängigen Ansprüchen der Erfindung gelöst.

Die Erfindung umfasst eine Vorrichtung nach Anspruch 1, ein Verfahren nach Anspruch 7 und ein Computerprogrammprodukt nach Anspruch 12.

In diesem Zusammenhang wird darauf hingewiesen, dass die in dieser Beschreibung und den Ansprüchen zur Aufzählung von Merkmalen verwendeten Begriffe "umfassen", "aufweisen", "beinhalten", "enthalten" und "mit", sowie deren grammatikalische Abwandlungen, generell als nichtabschließende Aufzählung von Merkmalen, wie z.B. Verfahrensschritten, Einrichtungen, Bereichen, Größen und dergleichen aufzufassen ist, die in keiner Weise das Vorhandensein anderer oder zusätzlicher Merkmale oder Gruppierungen von anderen oder zusätzlichen Merkmalen ausschließt.

Die Erfindung ermöglicht eine elektromagnetisch verträgliche pulsdauermodulierte Steuerung von elektrischen Verbrauchern in einem Kraftfahrzeug mit einer beliebigen Anzahl von Steuerkanälen.

Die Erfindung wird in ihren abhängigen Ansprüchen weitergebildet.

Um mit der Speichereinrichtung ohne Umweg über einen Prozessor kommunizieren zu können, ist die Steuersignalerzeugungseinrichtung vorteilhaft zum direkten Speicherzugriff auf die Speichereinrichtung ausgebildet, wobei günstigerweise nur genau eine Periode des Verlaufs der pulsdauermodulierten Steuersignale gespeichert wird.

Zur Reduzierung der benötigten Interrupts bei gleichzeitiger Beachtung der elektromagnetischen Verträglichkeit ist die Signaldatenbestimmungseinrichtung erfindungsgemäß dazu ausgebildet, die Steuerkanäle zu gruppieren und die Zeitpunkte des Pulsanstiegs eines jeden der Steuersignale innerhalb einer Steuerkanalgruppe versetzt zu den Zeitpunkten der Pulsanstiege der jeweils anderen Steuersignale innerhalb dieser Steuerkanalgruppe festzulegen.

Zur zuverlässigen Abfrage von den einzelnen Steuerkanälen zugeordneten Diagnosesignalen weist die Vorrichtung eine Diagnosesignalabfrage-Steuerungseinrichtung auf, die zur Steuerung der Abfrage eines einem Steuerkanal zugeordneten Diagnosesignals ausgebildet ist. In einer bevorzugten Ausführungsform ist die Diagnosesignalabfrage-Steuerungseinrichtung ausgebildet, die Abfrage des einem Steuerkanal zugeordneten Diagnosesignals in einem dem Pulsanstieg des Steuersignals in diesem Steuerkanal zeitlich nachfolgenden Diagnosezeitfenster zu steuern.

Um eine einfache Ausgestaltung der Steuerung zu erzielen, die eine verhältnismäßig geringe Prozessorleistung in Anspruch nimmt, ist der zeitliche Abstand der Pulsanstiege der Steuersignale innerhalb einer Gruppe erfindungsgemäß konstant.

Zur Steuerung der Abfrage des Diagnosesignals für das zuletzt in den Pulsanstieg geführte Steuersignals innerhalb der aktuellen Modulationsperiode ist jedem Steuerkanal einer Steuerkanalgruppe ein Diagnosesignal zugeordnet und die Diagnosesignalabfrage-Steuerungseinrichtung ausgebildet, die Diagnosezeitfenster innerhalb einer Periode der pulsdauermodulierten Steuersignale zu beenden. Der Hardwareaufwand zum Erhalt der Diagnosesignale kann, wie nachfolgend näher erläutert wird, verringert werden, wenn die Diagnosesignalabfrage-Steuerungseinrichtung dazu ausgebildet ist, die Diagnosefenster nicht überlappend anzuordnen und/oder bei einer Gruppierung der Steuerkanäle ein Diagnosezeitfenster für zumindest zwei Steuerkanalgruppen verwendet wird.

Weitere Merkmale der Erfindung ergeben sich aus der folgenden Beschreibung von Ausführungsbeispielen in Verbindung mit den Ansprüchen sowie den Figuren. Die einzelnen Merkmale können bei einer Ausführungsform gemäß der Erfindung je für sich oder zu mehreren verwirklicht sein. Bei der nachfolgenden Erläuterung einiger Ausführungsbeispiele der Erfindung wird auf die beiliegenden Figuren Bezug genommen, von denen
- Figur 1: eine Vorrichtung zur mehrkanaligen pulsdauermodulierten Steuerung von elektrischen Verbrauchern in einem Blockschaltbild darstellt,
- Figur 2: ein Beispiel für pulsdauermodulierte Steuersignale und Diagnosezeitfenster einer Vorrichtung nach Figur 1 mit 32 Steuerkanälen in einem Zeitdiagramm veranschaulicht und
- Figur 3: in einem Flussdiagramm die wesentlichen Schritte eines von einer Vorrichtung nach Figur 1 ausgeführten Verfahrens zeigt.

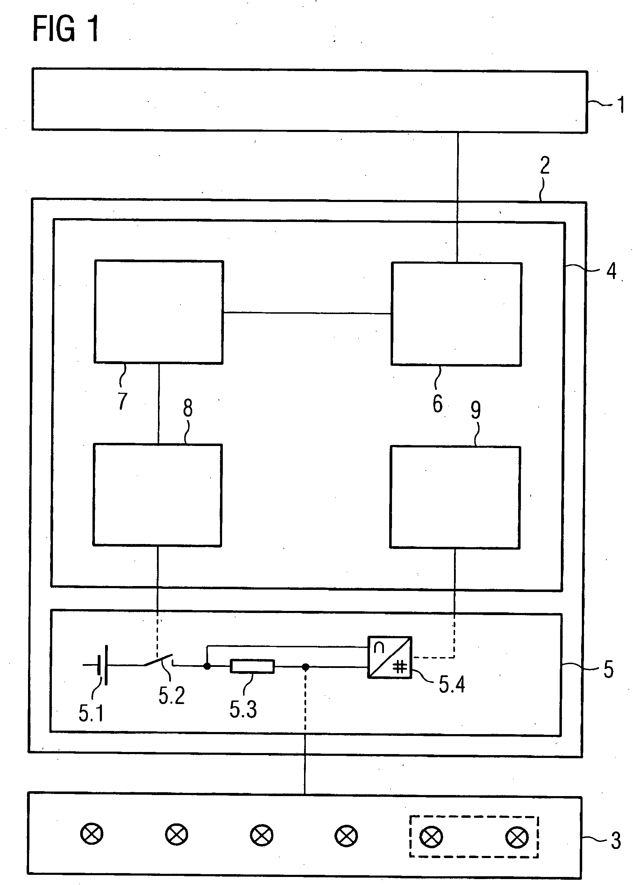

Figur 1 veranschaulicht in einem Blockschaltbild die wesentlichen Komponenten einer Vorrichtung zur mehrkanaligen pulsdauermodulierten Steuerung von elektrischen Verbrauchern in einem Kraftfahrzeug. Die Vorrichtung weist ein Hauptsteuergerät 1, ein Karosseriesteuergerät 2 und mehrere elektrische Verbraucher 3 auf. Da die dargestellte Steuerung vornehmlich der Steuerung Licht emittierender Einrichtungen in Kraftfahrzeugen dient, sind die elektrischen Verbraucher als Leuchten symbolisiert. Die gesteuerten elektrischen Verbraucher können jedoch auch andere Licht emittierenden Elemente, wie z.B. Lumineszenzdioden oder andere optoelektronische Einrichtungen, aber beispielsweise auch elektromechanische Einrichtungen und dergleichen umfassen. Eine prinzipielle Beschränkung für die Anzahl der über das Karosseriesteuergerät 2 im Einzelnen gesteuerten elektrischen Verbraucher ist nicht gegeben.

Die Vorrichtung zur mehrkanaligen pulsdauermodulierten Steuerung von elektrischen Verbrauchern ist in der Figur 1 schematisch vereinfacht dargestellt. Die Figur 1 zeigt daher nur diejenigen Komponenten der Vorrichtung, die zum Verständnis der vorliegenden Erfindung erforderlich sind. Auf die Darstellung weiterer, für den Betrieb der Vorrichtung erforderlicher oder deren weiteren Funktionsumfang bestimmender Komponenten wurde im Interesse einer übersichtlichen Darstellung verzichtet. Dennoch werden diese Komponenten als vorhanden angenommen.

Die Steuerung der elektrischen Verbraucher 3 erfolgt über das Hauptsteuergerät 1 in Verbindung mit dem Karosseriesteuergerät 2. Das Hauptsteuergerät 1 überträgt die Vorgaben für die Steuerung, d.h. den Füllgrad des jeweiligen pulsdauermodulierten Steuersignals für jeden einzelnen der angesteuerten elektrischen Verbraucher 3 bzw. jede einzelne Gruppe 3 von elektrischen Verbrauchern z.B. über ein Bussystem an das Karosseriesteuergerät 2. Gewünschtenfalls kann auch die Frequenz bzw. die Periodendauer der Steuersignale von dem Hauptsteuergerät 1 vorgegeben werden. In der Regel ist diese Frequenz jedoch zumindest für eine Gruppe von elektrischen Verbrauchern vorgegeben und muss dem Karosseriesteuergerät 2 daher nicht gesondert mitgeteilt werden. Üblicherweise wird die Modulation mit einer Modulationsfrequenz von etwa 100 Hz bis zu 400 Hz und darüber betrieben.

Die Bestimmung des Füllgrads bzw. des Tastverhältnisses der einzelnen Steuersignale erfolgt durch das Hauptsteuergerät entsprechend einem über eine Benutzerschnittstelle erhaltenen Fahrer- oder Insassenwunsch und/oder mittels selbsttätig wirkender technischer Einrichtungen, wie z.B. einer Umgebungslicht abhängigen Helligkeitssteuerung von Armaturenbeleuchtungen.

Das Karosseriesteuergerät 2 weist ein Logikmodul 4 und ein Leistungsmodul 5 auf. Das Logikmodul 4 umfasst im Allgemeinen eine (nicht dargestellte) hardwarebasierte Steueruntereinheit und eine softwarebasierte Steueruntereinheit. Die hardwarebasierte Steueruntereinheit enthält in der Regel eine MCU mit mehreren HW-PDM-Kanälen, die jeweils ein den Vorgaben des Hauptsteuergeräts 1 entsprechendes pulsdauermoduliertes Steuersignal erzeugen können. Jedes dieser Steuersignale kann an ein Stell- bzw. Schaltelement 5.2 des Leistungsmoduls 5 übertragen werden, das die Versorgungsgröße des zu steuernden elektrischen Verbrauchers entsprechend dem Steuersignal einstellt. Einerseits ist die Anzahl der HW-PDM-Kanäle jedoch sehr begrenzt und andererseits weisen diese Kanäle bezüglich der Beeinflussung der Steuersignale und eventuell zurückzulesender Diagnosesignale nur eine geringe Flexibilität auf.

Daher werden in der softwarebasierten Steueruntereinheit des Logikmoduls PDM-Steuerkanäle mit Hilfe von Treibern eingerichtet, die den Vorgaben des Hauptsteuergeräts 1 entsprechende pulsdauermodulierte Steuersignale für die verschiedenen zur Steuerung der elektrischen Verbraucher eingerichteten Steuerkanäle erzeugen. Diese PDM-Treiber bilden bei ihrer Ausführung in dem Logikmodul 4 des Karosseriesteuergeräts mehrere Einrichtungen aus. Vorzugsweise sind die Treiber als diagnosefähige Treiber ausgebildet, so dass neben einer Signaldatenbestimmungseinrichtung 6 und einer Steuersignalerzeugungseinrichtung 8 auch eine Diagnosesignalabfragesteuereinrichtung 9 in dem Logikmodul geschaffen wird. Zur weiter unten ausgeführten Speicherung von Signaldaten weist das Logikmodul ferner eine Speichereinrichtung 7 auf, von der die Steuersignalerzeugungseinrichtung 8 im Speicherdirektzugriff (englisch Direct Memory Access, abgek. DMA) Daten abrufen kann.

Zur Ausführung der PDM-Treiber umfasst die Logikuntereinheit zweckmäßig einen Prozessor, der zur Ausführung des die PDM-Treiber bildenden Algorithmus ausgebildet ist. Dieser Algorithmus ist in einer Speichereinrichtung des Karosseriesteuergeräts 2, beispielsweise der Speichereinrichtung 7, gespeichert und kann aus diesem Speicher von dem Prozessor zur Ausführung abgerufen werden.

Die Signaldatenbestimmungseinrichtung 6 empfängt von dem Hauptsteuergerät 1 die Pulsdauermodulationsvorgaben für die einzelnen Steuersignale, wie es von der beide verbindenden Linie in Figur 1 angedeutet ist. Bei allgemein vorgegebener Modulationsfrequenz beinhaltet die Pulsdauermodulationsvorgabe im Wesentlichen das für jedes Steuersignal einzustellende Tastverhältnis, d.h. das Verhältnis von Einschaltdauer des Steuerimpulses pro Modulationsperiode zur Dauer einer Modulationsperiode. Aus den empfangenen Daten der Pulsdauermodulationsvorgaben bestimmt die Signaldatenbestimmungseinrichtung 6 die in den jeweiligen Steuerkanälen zu verwendenden Pulsdauern der Steuersignalimpulse. Um Störungen anderer elektrischer wie elektronischer Einrichtungen innerhalb und außerhalb des Kraftfahrzeugs zu vermeiden, legt die Signaldatenbestimmungseinrichtung 6 die Pulsanstiege der Steuersignale nicht alle auf den gleichen Zeitpunkt fest. Dadurch wird erreicht, dass das es zu keinen großen Stromänderungen im Bordnetz des Kraftfahrzeugs kommt, die zu einer Aussendung elektromagnetischer Felder führen.

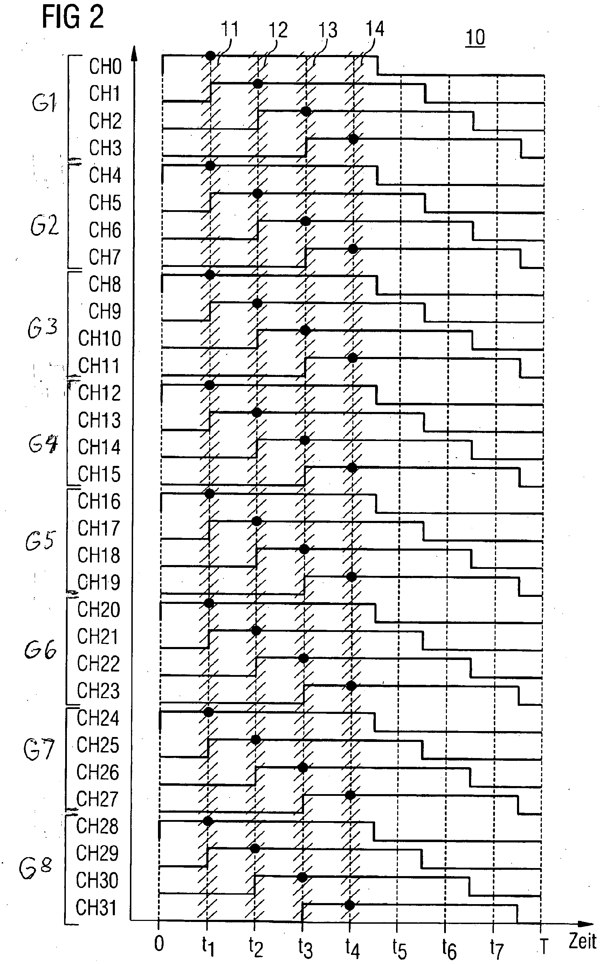

Vorzugsweise werden die Pulsanstiegszeitpunkte der einzelnen Steuersignale über einen bestimmten Zeitraum verteilt. Erfindungsgemäß werden die Zeitpunkte der einzelnen Signalimpulsanstiege gruppenweise chronologisch gestaffelt. Hierzu fasst die Signaldatenbestimmungseinrichtung 6 die zu steuernden Kanäle, beispielsweise die in der Figur 2 dargestellten 32

Steuerkanäle CH0 bis CH31 in Gruppen zusammen, z.B. wie der Figur 2 zu entnehmen in 8 Vierergruppen G1 bis G8. Innerhalb einer Gruppe werden die Pulsanstiegszeitpunkte der einzelnen Steuersignale gestaffelt, d.h. der Pulsanstieg des Steuersignal eines nachfolgenden Kanals CH1 (analog CH5, CH9, CH13, CH17, CH21, CH25, CH29) beginnt eine von der Signaldatenbestimmungseinrichtung 6 festgelegte Zeit nach dem Impulsanstieg des Steuersignals eines ersten Steuerkanals CH0 (analog CH4, CH8, CH12, CH16, CH20, CH24, CH28); entsprechend erfolgt der Pulsanstieg des Steuersignals eines dritten Kanals CH2 (analog CH6, CH10, CH14, CH18, CH22, CH26, CH30) um einen weiteren von der Signaldatenbestimmungseinrichtung 6 festgelegten Zeitraum versetzt nach dem Impulsanstieg des Steuersignals des jeweiligen zweiten Steuerkanals und der Pulsanstieg des Steuersignals eines vierten Kanals CH3 (analog CH7, CH11, CH15, CH19, CH23, CH27, CH31) erfolgt wiederum um einen weiteren von der Signaldatenbestimmungseinrichtung 6 festgelegten Zeitraum versetzt nach dem Impulsanstieg des Steuersignals des jeweiligen dritten Steuerkanals usw. je nach Anzahl der Steuerkanäle pro Gruppe.

Die Anzahl der in einer Gruppe zusammengefassten Steuerkanäle wird über die Vorgaben für die elektromagnetische Verträglichkeit bestimmt. Sie beträgt mindestens zwei.

Auf der Grundlage der für die einzelnen Steuersignale festgelegten Pulsanstiegszeitpunkte und Pulsdauern bestimmt die Signaldatenbestimmungseinrichtung 6 die Signaldaten, d.h. die Daten, die den Verlauf der Steuersignale der einzelnen Steuerkanäle CH0 bis CH31 wiedergeben. Diese Signaldaten werden in zeitdiskreter Form bestimmt, bei der die einzelnen Steuersignalwerte punktweise für bestimmte Zeitpunkte innerhalb einer Modulationsperiode angegeben sind. Diese Zeitpunkte weisen vorzugsweise regelmäßige Abstände auf und stimmen mit einer Taktfrequenz des Logikmoduls 4 überein.

Die Signaldaten werden von der Signaldatenbestimmungseinrichtung 6 in der Speichereinrichtung 7 gespeichert, wobei die Signaldaten den zeitlichen Verlauf der Steuersignale aller Steuerkanäle, im Beispiel der Figur 2 der Steuerkanäle CH0 bis CH31, in zeitdiskreter Form für eine Modulationsperiode enthalten.

Zum Erzeugen der Steuersignale ruft die Steuersignalerzeugungseinrichtung 8 die Signaldaten aus der Speichereinrichtung 7 ab. Vorzugsweise greift die Steuersignalerzeugungseinrichtung 8 über ein Bussystem hierzu direkt auf den Speicher 7 unter Verwendung einer DMA-Technik zu und setzt die Amplituden der einzelnen Steuersignale entsprechend den Signaldaten mit einer durch einen Taktgeber bestimmten zeitlichen Auflösung um. Da in der Speichereinrichtung bevorzugt nur die Signaldaten für eine Periode der pulsdauermodulierten Steuersignal enthalten ist, erfolgt die Umsetzung wiederholt ohne Unterbrechung. Die so erzeugten Steuersignale werden schließlich an das Leistungsmodul 5 des Karosseriesteuergeräts 2 übergeben, wobei das Steuersignal von jeweils einem Steuerkanal an jeweils ein Stellglied 5.2 des Leistungsmoduls 5 geleitet wird, das wie in Figur 2 veranschaulicht als Schaltelement zwischen der Bordstromversorgung 5.1 und dem jeweils angesteuerten Element der elektrischen Verbraucher 3 ausgeführt sein kann. Die Darstellung des Schaltelements als Schließer ist dabei rein symbolisch zu verstehen. In einer realen Ausführung werden mittels aktiver Halbleiterbauelemente, wie beispielsweise Transistoren oder dergleichen, aufgebaute Schaltglieder 5.2 bevorzugt.

Die Figur 2 zeigt ein Beispiel für den zeitlichen Verlauf der Steuersignale von 32 Steuerkanälen CH0 bis CH31 in einer Zeitdiagrammdarstellung 10. Gezeigt ist der Verlauf des Steuersignals eines jeden der 32 Steuerkanäle über eine sich entlang der Abszisse erstreckende Modulationsperiode der Dauer T. Auf der Ordinate sind die Kanalbezeichnungen bzw. -nummern in fallender Reihenfolge aufgetragen. Ohne Einschränkung der Allgemeinheit, jedoch zur übersichtlicheren Darstellung weisen die Steuersignale aller Steuerkanäle CH0 bis CH31 dasselbe Tastverhältnis auf. In einer realen Situation sind die Tastverhältnisse zwischen den Steuersignalen zweier Kanäle jedoch nur im Ausnahmefall gleich.

Die Steuerkanäle sind in dem Beispiel der Figur 2 wie oben erläutert in Gruppen G1 bis G8 eingeteilt, von denen jede jeweils 4 Steuerkanälen zu einer Gruppe vereint. Innerhalb jeder der Gruppen sind die Pulsanstiegszeiten der einzelnen Steuersignale gestaffelt, d.h. zeitlich versetzt zueinander angeordnet um starke Stromschwankungen zu vermeiden und die Gefahr von Funkstörungen zu verringern. Die gezeigten Signale werden, sofern sich keine Änderung in der Tastverhältnisvorgabe ergibt, periodisch wiederholt. Somit werden zu Beginn einer Modulationsperiode zurzeit t=0 jeweils nur 8 Kanäle eingeschaltet, d.h. der Pulsanstieg der Signale dieser Kanäle liegt am Beginn einer jeden Periode. Zu den Zeitpunkten t₁, t₂ und t₃ werden jeweils andere 8 Kanäle eingeschaltet, wobei pro Gruppe zu den jeweiligen Zeiten immer nur das Steuersignal eines Kanals eingeschaltet wird. Auf diese Weise werden von 32 Kanälen immer nur 8 Kanäle gleichzeitig eingeschaltet, womit die Vorgaben bezüglich der elektromagnetischen Verträglichkeit eingehalten werden können.

Das gleichzeitige Schälten von Kanälen aus verschieden Steuerkanalgruppen G1 bis G8 bietet den Vorteil die Anzahl der zum Erzeugen der Steuersignale erforderlichen Interrupts und damit die Belastung der Prozessorkapazität gering zu halten. Die Interruptserviceroutine (ISR) muss im dargestellten Beispiel nur mehr zu den Pulsanstiegszeiten t₀, t₁, t₂ und t₃ gestartet werden um die zum Ändern der Signalamplitude erforderlichen Interrupts auszuführen.

Wie bereits oben angeführt wurde, sind die PDM-Treiber diagnosefähig ausgeführt und bilden daher eine Diagnosesignalabfragesteuereinrichtung 9 innerhalb des Logikmoduls 4 des Karosseriesteuergeräts 2 aus. Die Diagnosesignalabfragesteuereinrichtung 9 empfängt den einzelnen Steuerkanälen CH0 bis CH32 zugeordnete Diagnosesignale, die z.B. über eine dem jeweiligen Steuerkanal zugeordnete Messeinrichtung 5.3 und Wandlereinrichtung 5.4 erzeugt werden und eine Information über die Umsetzung des Steuersignals des jeweiligen Steuerkanals enthalten. Ein nicht erschöpfendes Beispiel für eine Schaltung zum Erhalt eines Diagnosesignals für einen bestimmten Steuerkanal ist in Figur 2 wiedergegeben. Die gestrichelten Verbindungslinien deuten dabei an, dass es sich um eine Beschaltung für nur einen der vielen angesteuerten Kanäle handelt. Die Schaltung weist einen Stromspiegelausgang auf, der von den beiden Anschlüssen eines Strommesswiderstands 5.3 gebildet und mit dem Eingang eine Analog-Digitalwandlers 5.4 verbunden ist (statt eines Analog-Digitalwandlers kann jedoch auch eine digitale Statusrückmeldung verwendet werden). Der Messwiderstand 5.3 setzt in der dargestellten Beispielschaltung den im Verbraucherstromkreis fließenden Strom in eine Messspannung um, die der Analog-Digitalwandler (A/D-Wandler) schließlich in ein den Spannungswert repräsentierendes digitales Diagnosesignal umsetzt (In einer anderen Ausführungsform wird das digitale Diagnosesignal von der digitalen Statusrückmeldung gebildet). Die Diagnosesignalabfragesteuereinrichtung 9 steuert die Weitergabe des A/D-Wandlerausgangssignals an weitere Einrichtungen des Karosseriesteuergeräts, die das Diagnosesignal z.B. mit Sollwerten vergleichen und eventuell auf der Basis des Vergleichs Warnmeldungen ausgeben.

Um Diagnosesignale zu erhalten, die die überwachte Messgröße zuverlässig wiedergeben, muss nach dem Pulsanstieg des Steuersignals abgewartet werden, bis der Messwert am Ausgang des Messglieds bzw. der Messschaltung 5.3 eingeschwungen ist und dieser eingeschwungene Messwert vom A/D-Wandler umgesetzt wurde. Das Zurücklesen des Diagnosesignals eines Steuerkanals kann daher erst eine bestimmte Zeit nach dem Pulsanstieg des Steuersignals in diesem Steuerkanal erfolgen. Daher wird das Zurücklesen der Diagnosesignale von der Diagnosesignalabfragesteuereinrichtung 9 so gesteuert, dass die Diagnosesignale für jeden Kanal verzögert zum Pulsanstiegszeitpunkt abgefragt werden.

Die Abfrage der letzten Diagnosesignale erfolgt vorzugsweise noch innerhalb der Periode, in der der Pulsanstieg des zugehörigen Steuersignals erfolgte. Die Abfragezeitpunkte sind in Figur 2 für die einzelnen Steuersignale mit Punktsymbolen gekennzeichnet.

Durch die gruppenweise Anordnung der Steuerkanäle und damit der über sie bewirkten Signalsteuerung erfolgt auch das Zurücklesen der Diagnosesignale 'gruppenweise', da zu einem Zeitpunkt immer ein Diagnosesignal für einen Steuerkanal einer Gruppe abgefragt wird. Im gezeigten Beispiel werden daher zu einem Zeitpunkt t₁, t₂, t₃ oder t₄ immer nur acht Diagnosesignale gleichzeitig abgefragt. Um pro Modulationsperiode die Diagnosesignale aller Steuerkanäle CH0 bis CH31 abzufragen sind daher nur acht statt 32 A/D-Wandler erforderlich, wobei ein A/D-Wandler 4 Steuerkanäle im zeitlichen Multiplex bedienen kann. Die dargestellte Struktur ermöglicht somit eine Reduzierung des zur Diagnose benötigten Hardwareaufwands. Zur einfachen Steuerung der Pulsanstiegszeiten und der Diagnosezeitpunkte, sind die jeweiligen Zeiten äquidistant zueinander angeordnet.

Praktisch erstreckt sich die Abfrage der Diagnosesignale über einen gewissen Zeitraum, während dessen die Diagnoseabfragesteuerungseinrichtung 9 den A/D-Wandlerausgang weiterleitet. Dies ist in der Figur 2 durch die als schraffierte Bereiche dargestellten Diagnosezeitfenster 11, 12, 13 und 14 veranschaulicht. Je schmaler die schraffierten Bereiche, umso kürzer ist der zum Zurücklesen des Diagnosesignals verfügbare Zeitraum. Um einen A/D-Wandler oder eine andere Schaltungseinheit zur Ausgabe eines digitalen Diagnosesignals zur Diagnose von mehreren Steuerkanälen nutzen zu können, dürfen sich die durch die schraffierten Bereiche gekennzeichneten Zeiträume nicht überlappen.

Die Abfragen der Diagnosesignale müssen nicht unbedingt zeitgleich mit den jeweiligen Pulsanstiegen erfolgen. Durch versetzen der Pulsanstiege und/oder des Zurücklesens des Diagnosesignals relativ zum zugehörigen Interrupt kann, ohne die Prozessorkapazität zusätzlich zu belasten, eine gewisse Flexibilität bezüglich der Platzierung der Pulsanstiege und des Lesens der Diagnosesignale erreicht werden.

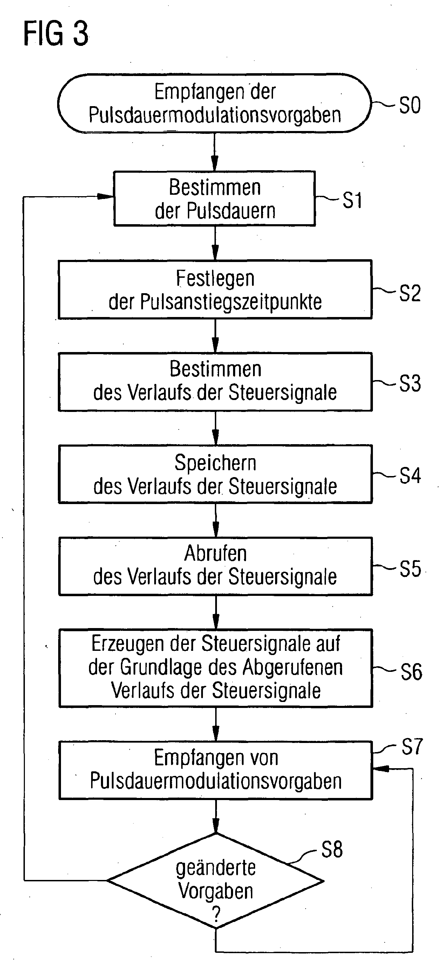

In der Figur 3 sind die wesentlichen Schritte des von einer Vorrichtung nach Figur 1 zum Erzeugen der Steuersignale ausgeführten Verfahrens in einem Flussdiagramm dargestellt.

Zu Beginn des Verfahrens empfängt die Signaldatenbestimmungseinrichtung 6 von dem Hauptsteuergerät 1 in Schritt S0 zunächst Pulsdauermodulationsvorgaben, wobei die Pulsdauermodulationsvorgaben insbesondere Vorgaben für die bei den einzelnen Signalen einzustellenden Tastverhältnisse beinhalten. Im nachfolgenden Schritt S1 bestimmt die Signaldatenbestimmungseinrichtung 6 aus den Pulsdauermodulationsvorgaben die jeweilige Dauer eines Steuersignalimpulses während einer Modulationsperiode. Zur Optimierung der Steuerung im Hinblick auf Vorgaben hinsichtlich der elektromagnetischen Verträglichkeit legt die Signaldatenbestimmungseinrichtung 6 unterschiedliche Pulsanstiegszeitpunkte für einige Steuersignalimpulse in Schritt S2 fest und bestimmt anschließend in Schritt S3 den Verlauf der Steuersignale unter Verwendung der zuvor bestimmten Pulsdauern und Pulsanstiegszeitpunkte. Dieser Verlauf wird von der Signaldatenbestimmungseinrichtung 6 in Schritt S4 in der Speichereinrichtung 7 abgelegt bzw. gespeichert. Die Steuersignalerzeugungseinrichtung 8 ruft den in der Speichereinrichtung 7 gespeicherten Signalverlauf in Schritt S5 per direktem Speicherzugriff ab und erzeugt in Schritt S6 des Verfahrens die einzelnen Steuersignale auf der Grundlage des abgerufenen Verlaufs der Steuersignale. Um Änderungen der Tastverhältnisvorgaben behandeln zu können, werden die Tastverhältnisvorgaben in Schritt S7 von der Signaldatenbestimmungseinrichtung 6 erneut von dem Hauptsteuergerät 1 empfangen. In Schritt S8 wird von der Signaldatenbestimmungseinrichtung 6 entschieden ob die neu empfangenen Vorgaben sich von den zuletzt empfangenen unterscheiden. Falls ja, wird das Verfahren in Schritt S1, falls nicht, in Schritt S7 fortgesetzt. Weitere Ausführungsformen des Verfahrens wurden bereits oben im Zusammenhang mit der Funktionsweise des Karosseriesteuergeräts 2 beschrieben.

### Bezugszeichenliste

- 1: Hauptsteuergerät
- 2: Karosseriesteuergerät
- 3: gesteuerte elektrische Verbraucher
- 4: Logikmodul des Karosseriesteuergeräts
- 5: Leistungsmodul des Karosseriesteuergeräts
- 5.1: Energiespeicher / Batterie des Bordnetzes
- 5.2: Schaltelement / Schaltglied
- 5.3: Messeinrichtung
- 5.4: Analog-Digitalwandler
- 6: Signaldatenbestimmungseinrichtung
- 7: Speichereinrichtung
- 8: Steuersignalerzeugungseinrichtung
- 9: Diagnosesignalabfragesteuereinrichtung
- 10: Zeitdiagramm
- 11: Diagnosezeitfenster 1
- 12: Diagnosezeitfenster 2
- 13: Diagnosezeitfenster 3
- 14: Diagnosezeitfenster 4
- CH0-CH31: Steuerkanäle
- G1-G8: Steuerkanalgruppen
- S0-S8: Verfahrensschritte

## Patentansprüche

1. Vorrichtung zum Erzeugen von pulsdauermodulierten Steuersignalen für zumindest zwei Steuerkanäle (CH0, ... , CH31), mit
- einer Signaldatenbestimmungseinrichtung (6) zum Bestimmen von Signaldaten, die den Verlauf des Steuersignals eines jeden der Steuerkanäle (CH0, ... , CH31) repräsentieren und
- einer Speichereinrichtung (7) zum Speichern der Signaldaten,
- einer Steuersignalerzeugungseinrichtung (8) zum Erzeugen der pulsdauermodulierten Steuersignale,
wobei
- die Signaldatenbestimmungseinrichtung (6) ausgebildet ist, die Signaldaten für eine Periode (0-T) der pulsdauermodulierten Steuersignale zu bestimmen und den Zeitpunkt des Pulsanstiegs von zumindest einem pulsdauermodulierten Steuersignal versetzt zu dem Zeitpunkt des Pulsanstiegs von wenigstens einem weiteren pulsdauermodulierten Steuersignal festzulegen,
- die Speichereinrichtung (7) zur Speicherung der Signaldaten in Form zeitdiskreter Steuersignaldaten für alle Steuerkanäle (CH0, ... , CH31) ausgebildet ist,
- die Steuersignalerzeugungseinrichtung (8) zum Erzeugen der pulsdauermodulierten Steuersignale auf der Grundlage der in der Speichereinrichtung gespeicherten Signaldaten ausgebildet ist,
- die Signaldatenbestimmungseinrichtung (6) ausgebildet ist, die Steuerkanäle (CH0, ..., CH31) in mindestens zwei Steuerkanalgruppen (G1, ..., G4) zu gruppieren, wobei die Anzahl der in einer Steuerkanalgruppe (G1, ..., G4) zusammengefassten Steuerkanäle mindestens zwei beträgt und die Signaldatenbestimmungseinrichtung (6) zudem ausgebildet ist, die Zeitpunkte des Pulsanstiegs eines jeden der Steuersignale innerhalb einer Steuerkanalgruppe (G1, ..., G4) versetzt zu den Zeitpunkten der Pulsanstiege der jeweils anderen Steuersignale innerhalb dieser Steuerkanalgruppe (G1, ..., G4) festzulegen, wobei der zeitliche Abstand der Pulsanstiege der Steuersignale innerhalb einer Steuerkanalgruppe (G1, ..., G4) konstant ist und Steuerkanäle aus verschieden Steuerkanalgruppen (G1,...., G4) gleichzeitig schalten.

2. Vorrichtung .nach Anspruch 1,
**dadurch gekennzeichnet,**
**dass** die Steuersignalerzeugungseinrichtung (8) zum direkten Speicherzugriff auf die Speichereinrichtung (7) ausgebildet ist.

3. Vorrichtung nach Anspruch 1 oder 2,
**gekennzeichnet durch**
eine Diagnosesignalabfrage-Steuerungseinrichtung (9) zur Steuerung der Abfrage eines einem Steuerkanal (CH0, ... , CH31) zugeordneten Diagnosesignals.

4. Vorrichtung nach Anspruch 3,
**dadurch gekennzeichnet,**
**dass** die Diagnosesignalabfrage-Steuerungseinrichtung (9) ausgebildet ist, die Abfrage des einem Steuerkanal (CH0, ..., CH31) zugeordneten Diagnosesignals in einem dem Pulsanstieg des Steuersignals in diesem Steuerkanal (CH0, ..., CH31) zeitlich nachfolgenden Diagnosezeitfenster (11, 12, 13, 14) zu steuern.

5. Vorrichtung nach Anspruch 3 oder 4,
**dadurch gekennzeichnet,**
**dass** jedem Steuerkanal (CH0, ..., CH31) einer Steuerkanalgruppe (G1, ..., G4) ein Diagnosesignal zugeordnet ist und die Diagnosesignalabfrage-Steuerungseinrichtung (9) ausgebildet ist, die Diagnosezeitfenster (11, 12, 13, 14) innerhalb einer Periode (0-T) der pulsdauermodulierten Steuersignale zu beenden.

6. Vorrichtung nach einem der Ansprüche 3 bis 5,
**dadurch gekennzeichnet,**
**dass** die Diagnosesignalabfrage-Steuerungseinrichtung (9) ausgebildet ist, die Diagnosefenster (11, 12, 13, 14) nicht überlappend anzuordnen.

7. Verfahren zum Erzeugen von pulsdauermodulierten Steuersignalen für zumindest zwei Steuerkanäle (CH0, ... , CH31), mit Schritten zum
- Empfangen der Tastverhältnisvorgabe (S0, S7) für jeden der Steuerkanäle (CH0, ... , CH31),
- Bestimmen der Pulsdauern (S1) der pulsdauermodulierten Steuersignale auf der Grundlage der empfangenen Tastverhältnisvorgaben,
- Festlegen der Zeitpunkte der Pulsanstiege (S2) der pulsdauermodulierten Steuersignale so, dass der Zeitpunkt des Pulsanstiegs von zumindest einem der pulsdauermodulierten Steuersignale zum Zeitpunkt des Pulsanstiegs von wenigstens einem weiteren pulsdauermodulierten Steuersignal versetzt erfolgt,
- Bestimmen des Verlaufs der pulsdauermodulierten Steuersignale (S3) auf der Grundlage der bestimmten Pulsdauern und Pulsanstiegszeitpunkten in zeitdiskreter Form,
- Speichern des bestimmten Verlaufs der pulsdauermodulierten Steuersignale (S4) in einer Speichereinrichtung (7),
- Abrufen des Verlaufs der pulsdauermodulierten Steuersignale (S5) aus der Speichereinrichtung (7) und
- Erzeugen der pulsdauermodulierten Steuersignale (S6) auf der Grundlage des von der Speichereinrichtung abgerufenen Verlaufs der pulsdauermodulierten Steuersignale, wobei
- die Steuerkanäle (CH0, ..., CH31) in mindestens zwei Steuerkanalgruppen (G1, ..., G4) gruppiert sind, wobei die Anzahl der in einer Steuerkanalgruppe (G1,..., G4) zusammengefassten Steuerkanäle mindestens zwei beträgt und wobei die Pulsanstiege der Steuersignale für eine Gruppe von Steuerkanälen (G1, ..., G4) zeitlich zueinander versetzt angeordnet sind und wobei der zeitliche Abstand der Pulsanstiege der Steuersignale innerhalb einer Steuerkanalgruppe (G1, ..., G4) konstant ist und Steuerkanäle aus verschieden Steuerkanalgruppen (G1, ..., G4) gleichzeitig schalten.

8. Verfahren nach Anspruch 7,
**dadurch gekennzeichnet,**
**dass** Abrufen des Verlaufs der pulsdauermodulierten Steuersignale (S5) aus der Speichereinrichtung (7) mittels Speicherdirektzugriff erfolgt.

9. Verfahren nach Anspruch 7 oder 8,
**dadurch gekennzeichnet,**
**dass** in der Speichereinrichtung (7) genau eine Periode (0-T) des Verlaufs der pulsdauermodulierten Steuersignale gespeichert wird.

10. Verfahren nach einem der Ansprüche 7 bis 9,
**dadurch gekennzeichnet,**
**dass** eine Abfrage eines einem Steuerkanal (CH0, ..., CH31) zugeordneten Diagnosesignals in einem dem Pulsanstieg des Steuersignals in diesem Kanal (CH0, ..., CH31) zeitlich nachfolgenden Diagnosezeitfenster (11, 12, 13, 14) erfolgt.

11. Verfahren nach Anspruch 10,
**dadurch gekennzeichnet,**
**dass** bei einer Gruppierung der Steuerkanäle ein Diagnosezeitfenster 11, 12, 13, 14) für zumindest zwei Steuerkanalgruppen (G1, ..., G4) verwendet wird.

12. Computerprogrammprodukt zum Erzeugen von pulsdauermodulierten Steuersignalen für zumindest zwei Steuerkanäle (CH0, ... , CH31), wobei das Computerprogrammprodukt eine Reihe physikalisch unterscheidbarer Zustände aufweist, die durch eine Datenverarbeitungseinrichtung eines Karosseriesteuergeräts (2) lesbar und ausführbar sind, und die eine Abfolge von Instruktionen darstellen, die auf der Datenverarbeitungseinrichtung ausgeführt ein Verfahren nach einem der Ansprüche 7 bis 11 durchführen.

## Claims

1. Apparatus for generating pulse-duration-modulated control signals for at least two control channels (CH0, ..., CH31), having
- a signal data determination device (6) for determining signal data representing the profile of the control signal for each of the control channels (CH0, ..., CH31), and
- a memory device (7) for storing the signal data,
- a control signal generation device (8) for generating the pulse-duration-modulated control signals,
- the signal data determination device (6) being designed to determine the signal data for one period (0-T) of the pulse-duration-modulated control signals and to stipulate the time of the pulse rise of at least one pulse-duration-modulated control signal such that it is offset with respect to the time of the pulse rise of at least one further pulse-duration-modulated control signal,
- the memory device (7) being designed to store the signal data in the form of time-discrete control signal data for all control channels (CH0, ..., CH31),
- the control signal generation device (8) being designed to generate the pulse-duration-modulated control signals on the basis of the signal data stored in the memory device,
- the signal data determination device (6) being designed to group the control channels (CH0, ..., CH31) into at least two control channel groups (G1, ..., G4), the number of control channels combined in one control channel group (G1, ..., G4) being at least two, and the signal data determination device (6) also being designed to stipulate the times of the pulse rise of each of the control signals within a control channel group (G1, ..., G4) such that they are offset with respect to the times of the pulse rises of the respective other control signals within this control channel group (G1, ..., G4), the interval of time between the pulse rises of the control signals within a control channel group (G1, ..., G4) being constant, and control channels from different control channel groups (G1, ..., G4) switching at the same time.

2. Apparatus according to Claim 1,
**characterized in that**
the control signal generation device (8) is designed for direct memory access to the memory device (7).

3. Apparatus according to Claim 1 or 2,
**characterized by**
a diagnostic signal query control device (9) for controlling the query of a diagnostic signal assigned to a control channel (CH0, ..., CH31).

4. Apparatus according to Claim 3,
**characterized in that**
the diagnostic signal query control device (9) is designed to control the query of the diagnostic signal assigned to a control channel (CH0, ..., CH31) in a diagnostic time window (11, 12, 13, 14) temporally following the pulse rise of the control signal in this control channel (CH0, ..., CH31).

5. Apparatus according to Claim 3 or 4,
**characterized in that**
a diagnostic signal is assigned to each control channel (CH0, ..., CH31) in a control channel group (G1, ..., G4), and the diagnostic signal query control device (9) is designed to end the diagnostic time windows (11, 12, 13, 14) within one period (0-T) of the pulse-duration-modulated control signals.

6. Apparatus according to one of Claims 3 to 5,
**characterized in that**
the diagnostic signal query control device (9) is designed to arrange the diagnostic windows (11, 12, 13, 14) such that they do not overlap.

7. Method for generating pulse-duration-modulated control signals for at least two control channels (CH0, ..., CH31), having steps for
- receiving the duty factor specification (S0, S7) for each of the control channels (CH0, ..., CH31),
- determining the pulse durations (S1) of the pulse-duration-modulated control signals on the basis of the received duty factor specifications,
- stipulating the times of the pulse rises (S2) of the pulse-duration-modulated control signals such that the time of the pulse rise of at least one of the pulse-duration-modulated control signals is offset with respect to the time of the pulse rise of at least one further pulse-duration-modulated control signal,
- determining the profile of the pulse-duration-modulated control signals (S3) on the basis of the determined pulse durations and pulse rise times in time-discrete form,
- storing the determined profile of the pulse-duration-modulated control signals (S4) in a memory device (7),
- retrieving the profile of the pulse-duration-modulated control signals (S5) from the memory device (7), and
- generating the pulse-duration-modulated control signals (S6) on the basis of the profile of the pulse-duration-modulated control signals which is retrieved from the memory device,
- the control channels (CH0, ..., CH31) being grouped into at least two control channel groups (G1, ..., G4), the number of control channels combined in one control channel group (G1, ..., G4) being at least two, and the pulse rises of the control signals for a group of control channels (G1, ..., G4) being arranged such that they are temporally offset with respect to one another, and the interval of time between the pulse rises of the control signals within a control channel group (G1, ..., G4) being constant, and control channels from different control channel groups (G1, ..., G4) switching at the same time.

8. Method according to Claim 7,
**characterized in that**
the profile of the pulse-duration-modulated control signals is retrieved (S5) from the memory device (7) by means of direct memory access.

9. Method according to Claim 7 or 8,
**characterized in that**
precisely one period (0-T) of the profile of the pulse-duration-modulated control signals is stored in the memory device (7).

10. Method according to one of Claims 7 to 9,
**characterized in that**
a diagnostic signal assigned to a control channel (CH0, ..., CH31) is queried in a diagnostic time window (11, 12, 13, 14) temporally following the pulse rise of the control signal in this channel (CH0, ..., CH31).

11. Method according to Claim 10,
**characterized in that**
a diagnostic time window (11, 12, 13, 14) is used for at least two control channel groups (G1, ..., G4) when the control channels are grouped.

12. Computer program product for generating pulse-duration-modulated control signals for at least two control channels (CH0, ..., CH31), the computer program product having a number of physically distinguishable states which can be read and executed by a data processing device of a body control device (2) and which represent a sequence of instructions which, when executed on the data processing device, carry out a method according to one of Claims 7 to 11.

## Revendications

1. Dispositif destiné à générer des signaux de commande modulés par modulation de largeur d'impulsion pour au moins deux canaux ce commande (CH0, ..., CH31), comportant
- un dispositif de détermination de données de signaux (6) destiné à déterminer des données de signaux qui représentent l'évolution du signal de commande de chacun des canaux de commande (CH0, ..., CH31) et
- un dispositif de stockage (7) destiné à stocker les données de signaux,
- un dispositif générateur de signal de commande (8) destiné à générer les signaux de commande modulés par modulation de largeur d'impulsion,
dans lequel
- le dispositif de détermination de données de signaux (6) est conçu pour déterminer les données de signaux pendant une période (0-T) des signaux de commande modulés par modulation de largeur d'impulsion et pour établir l'instant du front montant d'impulsion d'au moins un signal de commande modulé par modulation de largeur d'impulsion décalé par rapport à l'instant du front montant d'impulsion d'au moins un autre signal de commande modulé par modulation de largeur d'impulsion,
- le dispositif de stockage (7) est conçu pour stocker les données de signaux sous la forme de données de signaux discrètes dans le temps pour tous les canaux de commande (CH0, ..., CH31),
- le dispositif générateur de signaux de commande (8) est conçu pour générer les signaux de commande modulés par modulation de largeur d'impulsion sur la base des données de signaux stockées dans le dispositif de stockage,
- le dispositif de détermination de données de signaux (6) est conçu pour regrouper les canaux de commande (CH0, ..., CH31) dans au moins deux groupes de canaux de commande (G1, ..., G4), dans lequel le nombre des canaux de commande rassemblés dans un groupe de canaux de commande (G1, ..., G4) est égal à au moins deux, et le dispositif de détermination de données de signaux (6) est en outre conçu pour établir les instants du front montant d'impulsion de chacun des signaux de commande au sein d'un groupe de canaux de commande (G1, ..., G4) de manière décalée par rapport aux instants des fronts montants d'impulsions des autres signaux de commande respectifs au sein dudit groupe de canaux de commande (G1, ..., G4), dans lequel la distance temporelle entre les fronts montants d'impulsion des signaux de commande au sein d'un groupe de canaux de commande (G1, ..., G4) est constante et les canaux de commande de différents groupes de canaux de commande (G1, ..., G4) commutent de manière simultanée.

2. Dispositif selon la revendication 1,
**caractérisé en ce que** le dispositif générateur de signaux de commande (8) est conçu pour effectuer des accès directs en mémoire au dispositif de stockage (7).

3. Dispositif selon la revendication 1 ou 2,
**caractérisé par** un dispositif de commande d'interrogation de signal de diagnostic (9) pour commander l'interrogation d'un signal de diagnostic associé à un canal de commande (CH0, ..., CH31).

4. Dispositif selon la revendication 3,
**caractérisé en ce que** le dispositif de commande d'interrogation de signal de diagnostic (9) est conçu pour commander l'interrogation du signal de diagnostic associé à un canal de commande (CH0, ..., CH31) dans une fenêtre temporelle de diagnostic (11, 12, 13, 14) suivant temporellement le front montant d'impulsion du signal de commande dans ledit canal de commande (CH0, ..., CH31).

5. Dispositif selon la revendication 3 ou 4,
**caractérisé en ce qu'**un signal de diagnostic est associé à chaque canal de commande (CH0, ..., CH31) d'un groupe de canaux de commande (G1, ..., G4) et **en ce que** le dispositif de commande d'interrogation de signal de diagnostic (9) est conçu pour interrompre la fenêtre temporelle de diagnostic (11, 12, 13, 14) à l'intérieur d'une période (0-T) des signaux de commande modulés par modulation de largeur d'impulsion.

6. Dispositif selon l'une quelconque des revendications 3 à 5,
**caractérisé en ce que** le dispositif de commande d'interrogation de diagnostic (9) est conçu pour agencer les fenêtres de diagnostic (11, 12, 13, 14) de manière à ce qu'elles ne se chevauchent pas.

7. Procédé destiné à générer des signaux de commande modulés par modulation de largeur d'impulsion pour au moins deux canaux ce commande (CH0, ..., CH31), comportant les étapes destinées à
- recevoir l'instruction de rapport cyclique (S0, S7) pour chacun des canaux de commande (CH0, ..., CH31),
- déterminer les largeurs d'impulsion (S1) des signaux modulés par modulation de largeur d'impulsion sur la base des instructions de rapport cyclique reçues,
- établir les instants des fronts montants (S2) des signaux de commande modulés par modulation de largeur d'impulsion de manière à ce que l'instant du front montant d'impulsion d'au moins l'un des signaux de commande modulés par modulation de largeur d'impulsion suive de manière décalée dans le temps l'instant du front montant d'impulsion d'au moins un autre signal de commande modulé par modulation de largeur d'impulsion,
- déterminer l'évolution des signaux de commande modulés par modulation de largeur d'impulsion (S3) sur la base des largeurs d'impulsion déterminées et des instants des fronts montants d'impulsion sous une forme discrète dans le temps,
- stocker l'évolution déterminée des signaux de commande modulés par modulation de largeur d'impulsion (S4) dans un dispositif de stockage (7),
- extraire l'évolution des signaux de commande modulés par modulation de largeur d'impulsion (S5) du dispositif de stockage (7), et
- générer les signaux de commande modulés par modulation de largeur d'impulsion (S6) sur la base de l'évolution des signaux de commande modulés par modulation de largeur d'impulsion extraite du dispositif de stockage, dans lequel
- les canaux de commande (CH0, ..., CH31) sont regroupés dans au moins deux groupes de canaux de commande (G1, ..., G4), dans lequel le nombre des canaux de commande rassemblés dans un groupe de canaux de commande (G1, ..., G4) est égal à au moins deux, et dans lequel les fronts montants d'impulsion des signaux de commande pour un groupe de canaux de commande (G1, ..., G4) sont disposés de manière décalée temporellement les uns par rapport aux autres et dans lequel la distance temporelle des fronts montants d'impulsion des signaux de commande au sein d'un groupe de canaux de commande (G1, ..., G4) est constante et les canaux de commande de différents groupes de canaux de commande (G1, ..., G4) commutent de manière simultanée.

8. Procédé selon la revendication 7,
**caractérisé en ce que** l'extraction de l'évolution des signaux de commande modulés par modulation de largeur d'impulsion (S5) du dispositif de stockage (7) est effectuée au moyen d'un accès direct en mémoire.

9. Procédé selon la revendication 7 ou 8,
**caractérisé en ce qu'**exactement une période (0-T) de l'évolution des signaux de commande modulés par modulation de largeur d'impulsion est stockée dans le dispositif de stockage (7).

10. Procédé selon l'une quelconque des revendications 7 à 9,
**caractérisé en ce qu'**une interrogation d'un signal de diagnostic associé à un canal de commande (CH0, ..., CH31) est effectuée à l'intérieur d'une fenêtre temporelle de diagnostic (11, 12, 13, 14) suivant temporellement le front montant d'impulsion du signal de commande dans ledit canal (CH0, ..., CH31).

11. Procédé selon la revendication 10,
**caractérisé en ce qu'**une fenêtre temporelle de diagnostic (11, 12, 13, 14) est utilisée lors d'un regroupement des canaux de commande pour au moins deux groupes de canaux de commande (G1, ..., G4).

12. Produit de programme d'ordinateur destiné à générer des signaux de commande modulés par modulation de largeur d'impulsion pour au moins deux canaux de commande (CH0, ..., CH31), dans lequel le produit de programme d'ordinateur présente une série d'états différentiables physiquement, qui peuvent être lus et exécutés par un dispositif de traitement de données d'un appareil de commande de carrosserie (2), et qui représentent une séquence d'instructions qui mettent en oeuvre un procédé selon l'une quelconque des revendications 7 à 11 lorsqu'elles sont exécutées sur le dispositif de traitement de données.
